# EUROPEAN PATENT SPECIFICATION

(11) **EP 0 650 195 B1**
(45) Date of publication and mention of the grant of the patent: **15.12.2004**
(21) Application number: 94306993.0
(22) Date of filing: 26.09.1994
(51) Int. Cl.: H01L 27/06

(54) **MOS/bipolar device**
MOS/bipolar Anordnung
Dispositif MOS/bipolaire

(30) Priority: 22.10.1993 GB 9321819; 06.04.1994 US 223761
(43) Date of publication of application: 26.04.1995
(73) Proprietor: Zetex Plc, Chadderton, Oldham, OL9 8NP (GB)
(72) Inventor: Finney, Adrian Dr., Uppermill, Oldham OL3 6JW (GB); Casey, David Neil Dr., Ramsbottom, Lancashire BL0 0ES (GB)
(74) Representative: Holmes, Matthew Peter

(56) References cited:
- US-A- 4 855 244
- US-A- 4 859 878
- US-A- 5 101 257
- US-A- 5 247 200
- PATENT ABSTRACTS OF JAPAN vol. 012, no. 189 (E-616) 02 June 1988 & JP 62 293 678 A (FUJI ELECTRIC CO LTD) 21 December 1987

## Description

The present invention relates to a metal-oxide semiconductor (MOS)/bipolar semiconductor device.

It is known that bipolar transistors exhibit a low forward voltage drop (Vce) when driven into saturation. However, a bipolar transistor requires a relatively large amount of power to drive the device. Metal-oxide semiconductor field effect transistor (MOSFET) devices require little power to drive them, but exhibit relatively large voltage drops while turned on. An insulated gate bipolar transistor (IGBT) combines both a low on state voltage and a low drive requirement, but only if the IGBT supports more than 1 volt or so across the device.

US 5 101 257 discloses a semiconductor device comprising a bipolar transistor merged with a MOS transistor, the two transistors are separated by a side wall spacer and the bipolar transistor is self aligned with the MOS transistor. The drain region of the MOS device is also the active base region of the bipolar transistor. The bipolar transisitor has a first emitter region formed in the active base region and a second emitter region formed on the first emitter region and partially overlying the gate of the MOS transistor. A further device is disclosed in JP62293678.

A monolithically integrated semiconductor device comprising a bipolar transistor output stage having a base region and a collector region, wherein
the bipolar transistor is a vertically formed transistor comprising a first terminal being connected to a semiconductor substrate of first conductivity type forming the collector or emitter, the base region comprising material of second conductivity type formed on the substrate, a first region of first conductivity type connected to a second terminal; and
at least one short channel field effect transistor having a gate terminal of conducting material and comprising a second region of first conductivity type, the second region being either formed within the base region or in a further region of second conductivity type isolated from said base region by a region of the semiconductor substrate, said further region being connected to the base region by a metallic conductor,
wherein a third region of second conductivity type is formed within the second region a third terminal is connected to the second and third regions thereby suppressing thyristor action, and the gate terminal being adjacent sections of the second and third regions but insulated therefrom and from the third terminal;
wherein the at least one short channel field effect transistor is arranged to control a current flow in the base region and is separated from the collector region.

It is thus possible to provide a high power semiconductor device which has a low on state voltage drop and a low drive requirement substantially irrespective of the potential supported by the device.

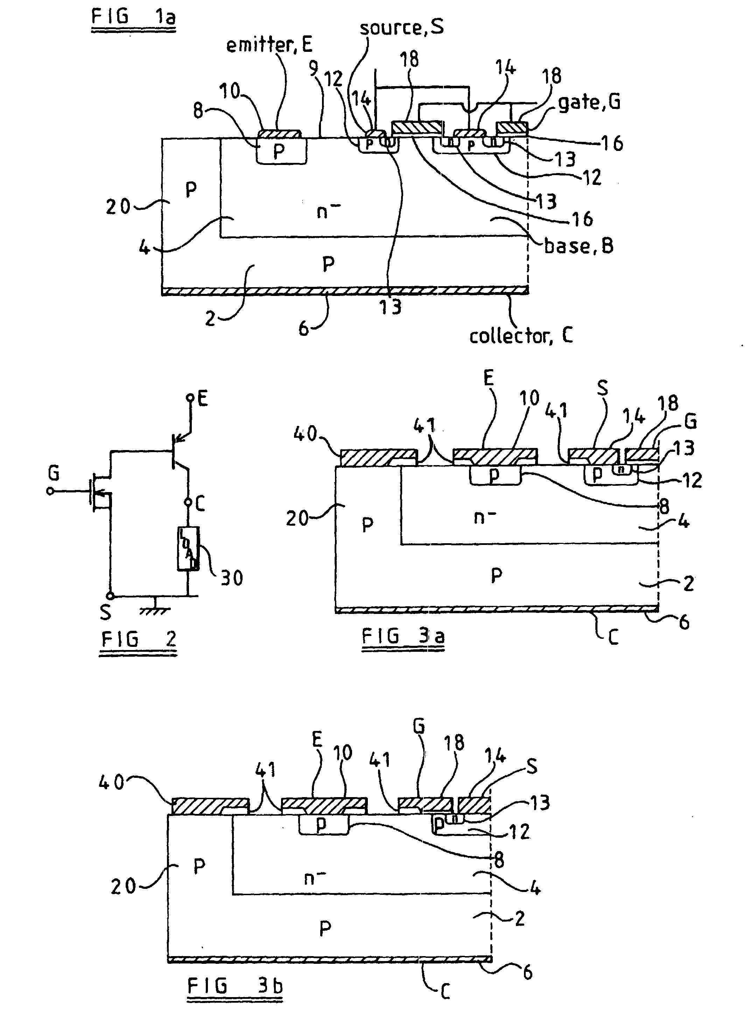

The term "short channel" is well known. in the art, however, by way of explanation, it generally refers to a device structure where the regions 12 and 13 shown in Figure 1a of the accompanying drawings are defined at or close to the edge of the gate G. the difference in the lateral extent of the regions 12 and 13 defines a surface channel region.

Advantageously the or each MOSFET operates in an enhancement mode, such that the device inhibits current flow in the base region of the bipolar transistor when the potential at a gate terminal of the MOSFET is less than a threshold voltage measured with respect to a source terminal of the MOSFET.

When the first semiconductor is a P type semiconductor and the second semiconductor is an N type semiconductor, the first terminal may be a collector, the second terminal may be an emitter and the third terminal is a source. However, in an alternative construction, the first terminal may be an emitter and the second terminal may be a collector.

Advantageously a metallic conductor may extend from part of the epitaxial layer adjacent the second region to part of the epitaxial layer adjacent the first region or to regions of the second semiconductor formed within the first region, thereby distributing the base current around the first region.

Advantageously a region of semiconductor of the same type as the substrate extends, at the edges of a die on which the device is fabricated, from the substrate to the surface of the device. Thus the depletion region may be prevented from spreading to the edge of the die.

Advantageously the device is provided with at least one field plate. Additionally or alternatively rings of p type and/or n type semiconductor may be formed within the epitaxial layer, for example, by diffusion. Such rings are known as kao rings. The provision of kao rings and/or field plates increases the voltage that the device can withstand before breakdown occurs.

Advantageously the bipolar transistor may have a less doped collector region, for example a p⁻ region, adjacent the collector-base interface and/or the base may have a region of increased doping adjacent the emitter region. It is thus possible to arrange for breakdown to occur in the bulk of the device before the depletion region across the collector-base junction reaches through to the emitter.

Preferably a heavily doped region of the same type of semiconductor as the epitaxial layer is formed at the substrate-epitaxial layer interface beneath the MOSFET. Such a region suppresses the operation of a vertical parasitic thyristor and reduces the operation of a vertical parasitic IGBT.

Advantageously lifetime killers, such as gold and irradiation damage, may be used to reduce the gain of a or each parasitic thyristor and a or each parasitic IGBT. Lifetime killers may also be used to increase the turn off speed of the device.

Advantageously anode shorts may be provided so as to increase the switching speed of the device without the need for lifetime killers. Both anode shorts and lifetime killers may be included within the same device.

The present invention will further be described, by way of example, with reference to the accompanying drawings, in which:
Figure 1a is a schematic representation of a device constituting a first embodiment of the present invention and having a vertical MOSFET;
Figure 1b is a schematic representation of a similar device having a lateral MOSFET in place of the vertical MOSFET;
Figure 2 is an equivalent circuit of the device shown in Figure 1;
Figures 3a, 3b and 4 to 6 are diagrams of configurations for increasing the voltage rating of devices constituting embodiments of the present invention;
Figure 7 is a diagram of a device constituting an embodiment of the present invention having regions to ensure that the bulk of the device breaks down before the collector-base depletion region reaches through to the emitter;
Figure 8 is a diagram of a device having doping to reduce the effect of a parasitic thyristor and a parasitic IGBT;
Figure 9 is a diagram of a device having anode shorts within the emitter region thereof so as to decrease device turn off time;
Figures 10 and 11 show devices having a conductor to improve base current distribution around the emitter region;
Figure 12 is a schematic diagram of a device constituting an embodiment of the present invention and having an emitter formed by the substrate;
Figure 13 is an equivalent circuit of three devices of the type shown in Figure 12, having a common emitter;
Figure 14 is a cross-section of the emitter matrix structure of Figure 10 along the direction of line A; and
Figure 15a is a schematic diagram of a lateral MOSFET which can be substituted in place of the vertical MOSFET, as shown in Figure 15b, in any of the devices shown in Figures 4 to 12.

In the drawings, the vertical broken line represents a plane of device symmetry.

Figure 1a shows the structure of a device comprising a p type semiconductor substrate 2 having an n⁻ type epitaxial layer 4 formed thereon. The substrate 2 is connected, on a side thereof opposed to the epitaxial layer 4, to a first metallic conductor 6. A first p type region 8 is formed at a surface 9 of the epitaxial layer 4. The region 8 is in contact with a second metallic conductor 10. The p type substrate 2 forms a collector C, the epitaxial layer 4 forms a base region and the first p type region 8 forms an emitter E of a PNP transistor. The first and second metallic conductors 6 and 10 provide electrical connections to the collector C and the emitter E, respectively. Further p type regions 12 are formed at the surface 9 of the epitaxial layer 4. At least one n type region 13 is formed within each of the further p type regions 12. Third metallic conductors 14 are provided in contact with first parts of the further p regions 12 and first parts of the n type regions 13. Fourth conductors 18 are disposed adjacent second parts of the further p regions 12 and second parts of the n type regions 13, but are insulated therefrom by thin oxide layers 16. The p and n regions 12 and 13, together with the insulating layer 16 and the conductors 14 and 18 form an N channel vertical MOSFET which, in use, supplies base current to the PNP bipolar transistor. The third metallic conductors 14 act as the source terminals S of the MOSFET, whereas the fourth conductors 18 act as the gate contacts of the MOSFET. A similar arrangement is shown in Figure 1b, where the positions of the source and gate have been changed so as to form a N channel lateral MOSFET. The fourth conductors can be metallic or be

The MOSFET is very efficient since it has a short channel DMOS structure. Such a structure provides a threshold voltage which is substantially independent of bias conditions. The bipolar transistor is also efficient since it has a vertical power structure.

Figure 2 is an equivalent circuit of the device illustrated in Figures 1a and 1b, including an external load 30 so as to illustrate a circuit incorporating the device.

The device can be used as a high side switch (i.e. connected between a load and a positive supply) which is driven like a conventional N channel enhancement mode MOSFET, that is, not conducting when V_{GS} =0 volts and conducting when V_{GS} is greater than a threshold voltage of typically 1 to 2 volts.

The structure of the device may give rise to the formation of parasitic IGBTs. A vertical IGBT is formed from the MOS gate, n type region 13, the p type region 12, the n- type epitaxial layer 4 and the p type substrate 2. A lateral IGBT is formed by the MOS gate, n type region 13, the p type region 12, the n- type epitaxial layer 4 and the p type region 8. Like all IGBTs, these contain parasitic thyristors which must be prevented from "latching up". Fortunately techniques which have been developed to suppress parasitic thyristors in devices such as insulated gate bipolar transistors, such as improving the emitter/base short within one of the two bipolar transistors within the parasitic thyristor by, for example, the zig-zag structure disclosed in "Diagonal Source Gives Smaller IGBTs", "Electronic Engineering" April 1993, page 55, are suitable for use within this device.

If the bipolar transistor within the structure is to be used in a saturated mode of operation, then the lateral MOSFET structure shown in Figures 1b, 3b and 15a is more suitable for driving the bipolar transistor. This is because the current in the lateral MOSFET is directed away from the parasitic vertical IGBT. Consequently less source current is required to obtain a given collector current.

In the non-conducting state, the applied voltage appears across the collector-base junction of the bipolar transistor. The depletion region is prevented from spreading to the side edge of the device by the provision of a further p type region 20 (Figures 1a and 1b) which connects the surface 9 with the substrate 2. The region 20 may be formed, for example, by a deep diffusion down from the surface 9 and/or up from an initially buried p⁺ region. The device woulld have a relatively leaky collector-base junction without the provision of the further p type region 20. The device is also capable of supporting a supplied voltage across the collector-source and emitter source junctions.

Techniques which are known to improve the voltage capability of a planar junction may advantageously be incorporated within an embodiment of the present invention. Figures 3a, 3b and 4 to 6 illustrate devices similar to that shown in Figures 1a and 1b. Like parts are labelled with the same reference numbers as used in Figures 1a and 1b and parts of the device have been omitted for the sake of clarity.

In the embodiment shown in Figure 3a, a field plate 40 has been formed to cover the surface 9 at the junction between the p type region 20 and the n⁻ epitaxial layer 4. The field plate is a metallic conductor in electrical contact with the p type region 20 and in close proximity with, but insulated from, the epitaxial layer 4 by an insulating layer 41. The insulating layer 41 may, for example, be an oxide layer. Similarly the source and emitter contacts 14 and 10, respectively, may be laterally extended to over-hang the epitaxial layer 4, and be insulated therefrom, so as to form field plates. The or each field plate reduces the electric field intensity in the region of its associated junction. This in turn reduces the likelihood of breakdown and in turn allows the device to be rated for use with higher voltages.

A similar arrangement is shown in Figure 3b. Here the gate and emitter contacts are laterally extended to overhang the epitaxial layer 4.

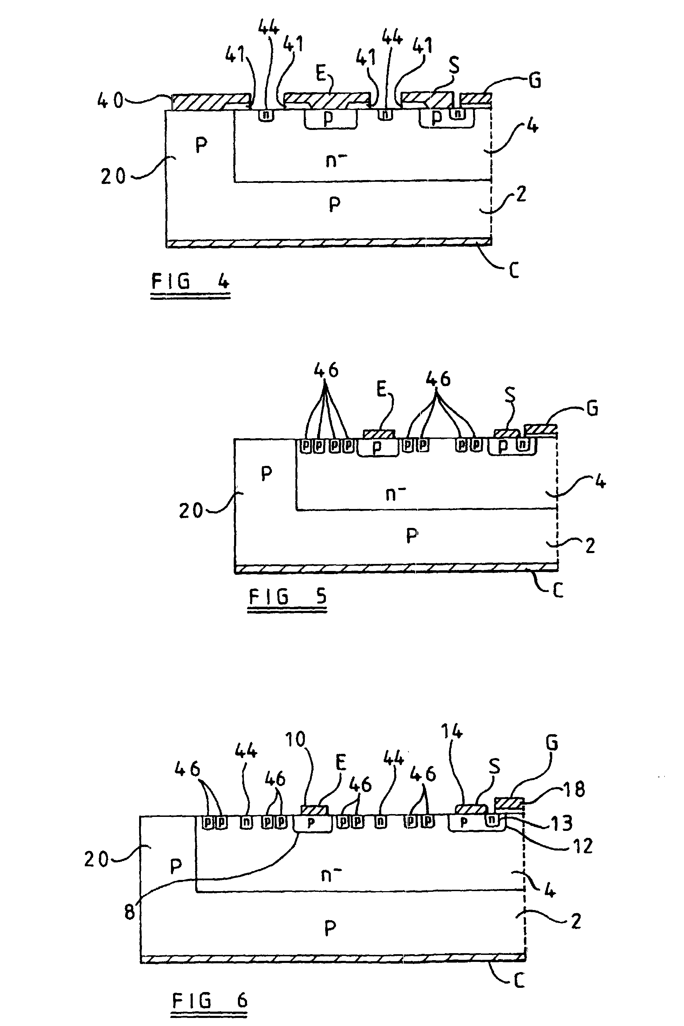

The device shown in Figure 4 is similar to that shown in Figure 3a. However, it possesses diffused rings 44 in the epitaxial layer 4 adjacent the surface 9. The rings 44 are formed of regions of n type semiconductor. The provision of the rings 44 also increases the voltage rating of the device.

Figures 5 and 6 shows further embodiments in which the field plate is omitted and in which kao rings have been formed. In the embodiment illustrated in Figure 5, the kao rings 46 are formed of p type semiconductor. The device illustrated in Figure 6 has n type rings 44 interposed between pairs of p type kao rings 46. Field plates may also be provided.

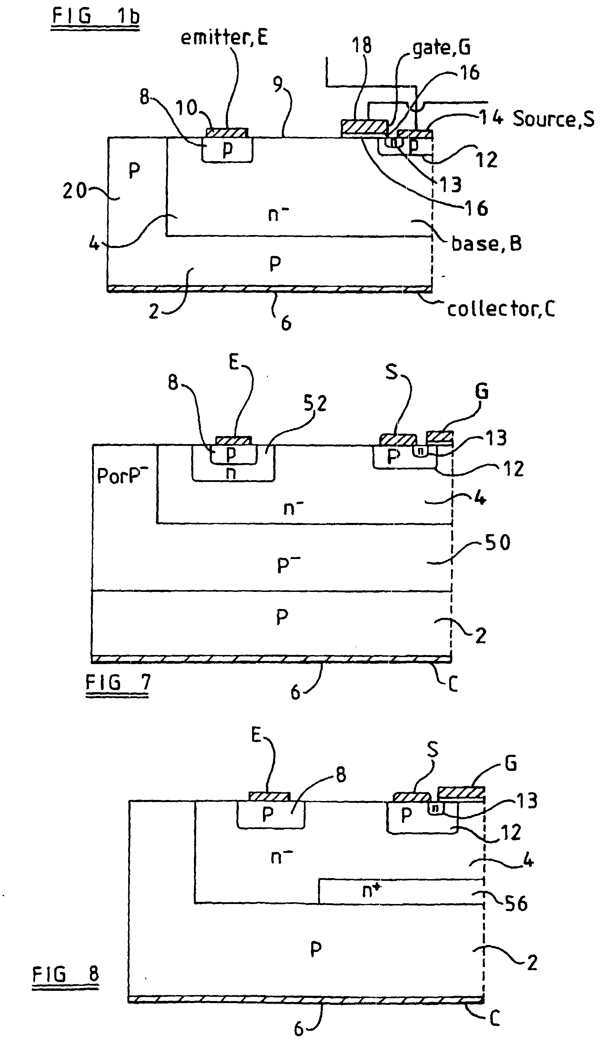

It is advantageous that, as the collector-base potential is increased, the device should breakdown in the bulk thereof before the depletion region across the collector-base junction reaches through to the emitter 8. Whilst this is not essential, it makes the characteristics of the device more predictable since, for example, the breakdown voltage is substantially independent of the gain of the bipolar transistor. This can be achieved by the inclusion within the collector region 2 of a less doped p⁻ region 50 and/or by increasing the doping in a region 52 of the base (i.e. the epitaxial layer 4) adjacent the emitter, as shown in Figure 7.

In addition to the prior art method described to suppress the action of the parasitic IGBTs and thyristors, the lateral parasitic thyristor can be further suppressed by increasing the doping in the region 52 of the base which surrounds the emitter 8. This is because the increase in the dopant concentration reduces the gain of the p emitter, n⁻ epitaxial and p body bipolar component.

The effect of the vertical parasitic thyristor can be reduced by including a heavily doped n⁺ region 56 at the collector-base interface under the DMOSFET, as shown in Figure 8. Such doping reduces the gain of the collector, epitaxial, body bipolar component.

The techniques for suppressing the parasitic thyristors can be made more effective by the addition of "lifetime killers", such as gold and/or irradiation damage because these have a disproportionally large effect on reducing the gain of the poorer bipolar components within the parasitic thyristors compared with the intended PNP power bipolar transistor.

When the MOSFET is turned off, the base of the bipolar transistor becomes isolated and this can result in a relatively long turn off time, since the bipolar transistor continues to conduct until the minority carriers within the base have decayed. The use of "lifetime killers" as disclosed above, reduce the decay time and hence allow the device to turn non-conducting more quickly.

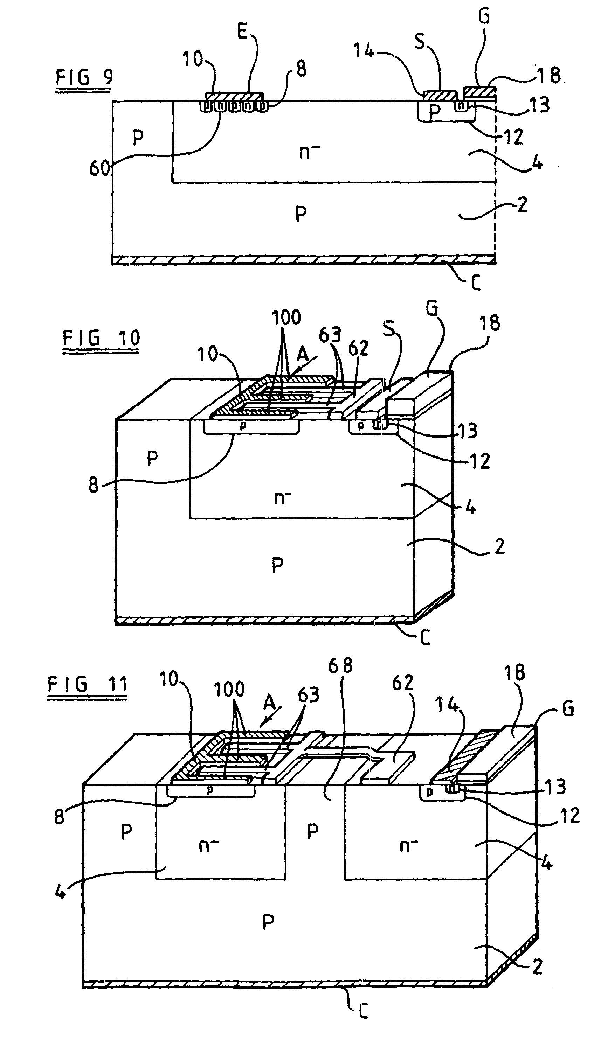

A further way of reducing the turn off time of the device is to provide anode shorts to provide a path to conduct the carriers at turn off. Such an arrangement is shown in Figure 9, where n type regions 60 are formed within the emitter region 8, so as to form a p-n-p-n-p structure beneath the emitter contact 10. Such an arrangement increases switching speed without the need to introduce lifetime killers.

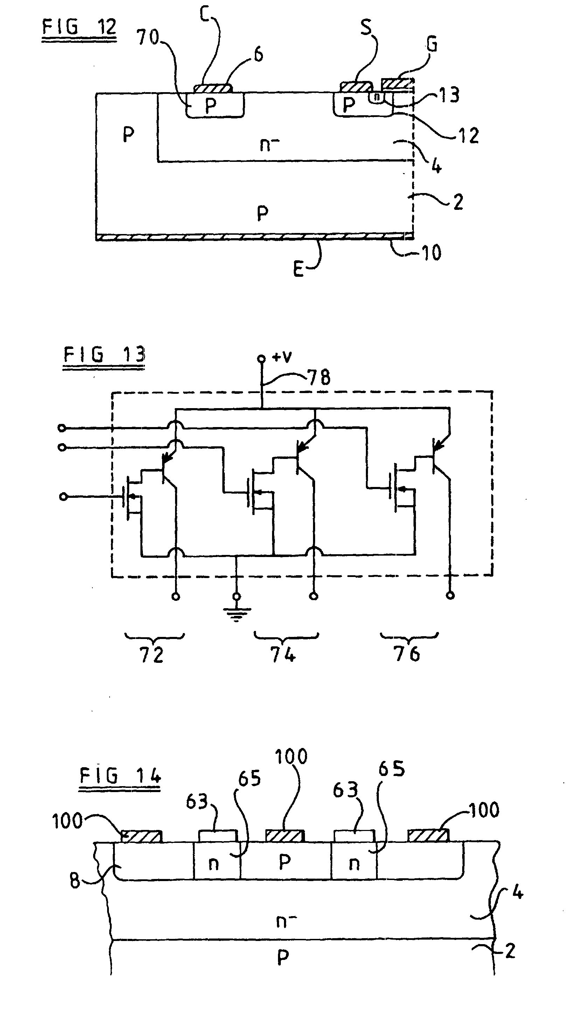

Improved performance can be obtained by using a metallic conductor 62 to distribute the base current more effectively throughout the emitter region 8, for example, the matrix structure disclosed in Electronic Engineering Times, 3rd June, 1991, is an efficient way of distributing the current, as shown in Figure 10. The emitter region 8 is provided with an emitter contact 10 having a plurality of fingers 100. Similarly the metallic conductor 62 has a plurality of fingers 63 which are interdigitated with, but not touching, the fingers 100. The fingers 100 are in contact with the emitter region 8. The fingers 63 are insulated from the emitter region 8 by an oxide layer. However, there are regular breaks in the oxide layer. The breaks correspond to the positions of columns 65 of n type semiconductor which are within the emitter region 8, and which connect the fingers 63 with the epitaxial layer 4, as shown in Figure 14, which is a cross-section through the emitter matrix along the direction of the arrow A in Figure 10. Thus, the distribution of the base current throughout the emitter region is much improved, without sacrificing much emitter area.

A further embodiment, in which the MOSFET and the bipolar transistor are isolated from each other by a p type region 68, is shown in Figure 11. The only path between the transistors is provided by the metallic conductor 62, otherwise the structure of the emitter region is as described above with reference to Figures 10 and 14.

A gap can be provided between the conductor 62 and the further region 12, as shown in Figure 11, so as to improve the break down voltage of the device. Such a gap can also be included in the embodiment shown in Figure 10.

As a further alternative, the substrate 2 may act as the emitter and a collector region may be formed by a p type region 70 within the epitaxial layer 4, as illustrated in Figure 12. Thus, the collector and emitter terminals are effectively interchanged. This is less efficient, but the efficiency of this structure can be greatly enhanced by utilising the matrix structure. An advantage of interchanging the collector and emitter regions is that a common positive connection may be made to the substrate and a plurality of devices may be encapsulated within a single package or a plurality of die may be attached to a single contact. The connections made to the upper surface can be associated with individual devices and be connected to various loads which are independently connected to ground. This is particularly useful in common earth applications, such as in automotive systems. An equivalent circuit of a device is shown in Figure 13. Three devices 72, 74 and 76 are encapsulated within a single package and share a common anode 78.

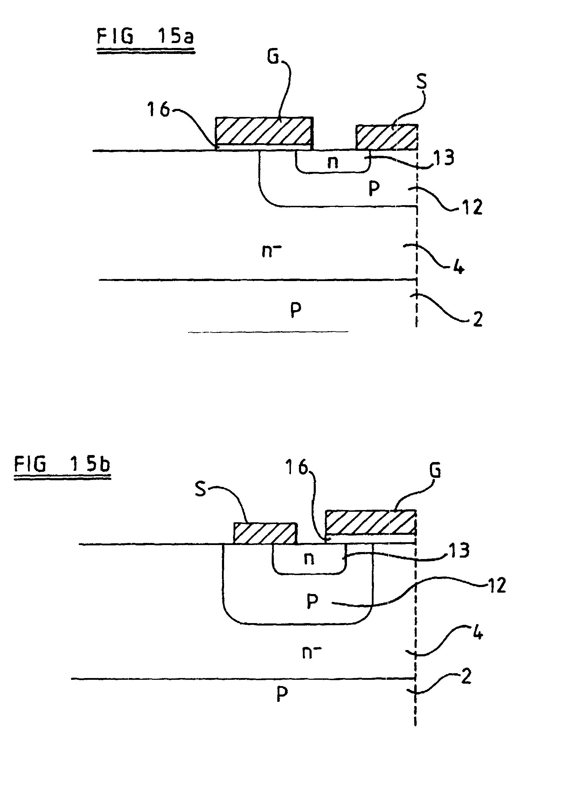

A lateral MOSFET, as shown in Figure 15a, can be used in place of the vertical MOSFET, an example of which is shown in Figure 15b, in any of the preceding embodiments described hereinbefore.

Protection diodes may be provided using known techniques to prevent static damage to the gate of the MOSFET.

It is thus possible to provide a power switching device having a low voltage drop in the conducting state and requiring very little drive power. The p type and n type regions may be interchanged so as to provide a device comprising an NPN bipolar transistor driven by a P channel MOSFET.

## Claims

1. A monolithically integrated semiconductor device comprising a bipolar transistor output stage having a base region (4) and a collector region (2), wherein
the bipolar transistor is a vertically formed transistor comprising a first terminal (6) being connected to a semiconductor substrate (2) of first conductivity type forming the collector or emitter, the base region (4) comprising material of second conductivity type formed on the substrate, a first region (8) of first conductivity type connected to a second terminal (10); and
at least one short channel field effect transistor having a gate terminal (18) of conducting material and comprising a second region (12) of first conductivity type, the second region (12) being either formed within the base region (4) or in a further region of second conductivity type isolated from said base region by a region of the semiconductor substrate (68), said further region being connected to said base region by a metallic conductor,
wherein a third region (13) of second conductivity type is formed within the second region (12), a third terminal (14), is connected to the second and third regions (12, 13) thereby suppressing thyristor action, and the gate terminal (18) being adjacent sections of the second and third regions (12, 13) but insulated therefrom and from the third terminal (14);
wherein the at least one short channel field effect transistor is arranged to control a current flow in the base region (4) and is separated from the collector region (2).

2. A semiconductor device as claimed in Claim 1, **characterised in that** the at least one short channel field effect transistor has a short channel vertical DMOS structure.

3. A semiconductor device as claimed in Claim 1, **characterised in that** the at least one short channel field effect transistor has a short channel lateral DMOS structure.

4. A semiconductor device as claimed in any one of the preceding claims, **characterised in that** the at least one short channel field effect transistor has a source terminal (14), the at least one short channel field effect transistor being arranged to operate in an enhancement mode so as to inhibit current flow in the base region (4) when a potential at the gate terminal (18) is less than a threshold voltage measured with respect to the source terminal (14).

5. A device as claimed in any one of the preceding claims,
**characterised in that** the material of first conductivity type is a P type semiconductor, the material of second conductivity type is an N type semiconductor, the first terminal (6) is a collector, the second terminal (10) is an emitter, the third terminal (14) is a source, and the substrate (2) is the collector region.

6. A device as claimed in any one of Claims 1 to 4, **characterised in that** the material of first conductivity type is a P type semiconductor, the material of second conductivity type is an N type semiconductor, the first terminal (10) is an emitter, the second terminal (6) is a collector, the third terminal (14) is a source, and said first region (70) is the collector region.

7. A device as claimed in any one of the preceding claims, **characterised by** a metallic conductor (62, 63) extending from part of the base region (4) adjacent the second region (12) to regions (65) of the material of second conductivity type formed within the first region (8), the metallic conductor being arranged to distribute a base current around the first region.

8. A device as claimed in any one of Claims 1 to 6, **characterised by** a metallic conductor (62, 63) extending from part of the base region (4) adjacent the second region (12) to a further part of the base region adjacent the first region (8), said metallic conductor being arranged to distribute a base current around the first region.

9. A device as claimed in any one of the preceding claims, **characterised in that** the device is formed in a die comprising a substrate (2) of a material of first conductivity type, and a fourth region (20) comprising the material of first conductivity type, said die having edges and a surface, and the fourth region (20) extending, at the edges of the die, from the substrate to the surface.

10. A device as claimed in any one of the preceding claims, **characterised by** further comprising at least one field plate (40).

11. A device as claimed in any one of the preceding claims, **characterised by** further comprising rings (46) of the material of first or second conductivity type within the base region (4).

12. A device as claimed in any one of the preceding claims, **characterised by** further comprising a fifth region (50) of semiconductor intermediate the substrate (2) and the base region (4), the fifth region (50) having a lower doping concentration than the substrate.

13. A device as claimed in any one of the preceding claims, **characterised by** further comprising a sixth region (52) of semiconductor intermediate the base region (4) and the first region (8), the sixth region (52) being more heavily doped than the base region (4).

14. A device as claimed in any one of the preceding claims, **characterised by** further comprising a heavily doped region (56) of the base region (4) at an interface between the base region (4) and the substrate (2) beneath the at least one short channel field effect transistor.

15. A device as claimed in Claim 5, further comprising anode shorts (60) adjacent the second terminal.

## Patentansprüche

1. Monolithisch integriertes Halbleiterbauelement, das aufweist: eine Bipolartransistor-Ausgangsstufe mit einem Basisbereich (4) und einem Kollektorbereich (2), wobei
der Bipolartransistor ein vertikal ausgebildeter Transistor ist, der aufweist: einen ersten Pol (6), der mit einem Halbleitersubstrat (2) von einem ersten Leitfähigkeitstyp verbunden ist, das den Kollektor oder Emitter bildet, den Basisbereich (4), der auf dem Substrat ausgebildetes Material von einem zweiten Leitfähigkeitstyp aufweist, einen ersten Bereich (8) vom ersten Leitfähigkeitstyp, der mit einem zweiten Pol (10) verbunden ist; und
mindestens einen Kurzkanal-Feldeffekttransistor mit einem Gate-Pol (18) aus leitfähigem Material, der einen zweiten Bereich (12) vom ersten Leitfähigkeitstyp aufweist, wobei der zweite Bereich (12) entweder innerhalb des Basisbereichs (4) oder in einem weiteren Bereich vom zweiten Leitfähigkeitstyp ausgebildet ist, der von dem Basisbereich durch einen Bereich des Halbleitersubstrats (68) isoliert ist, wobei der weitere Bereich durch einen metallischen Leiter mit dem Basisbereich verbunden ist,
wobei innerhalb des zweiten Bereichs (12) ein dritter Bereich (13) vom zweiten Leitfähigkeitstyp ausgebildet ist, ein dritter Pol (14) mit dem zweiten und dem dritten Bereich (12,13) verbunden ist und dadurch eine Thyristorwirkung unterdrückt, und wobei der Gate-Pol (18) aus benachbarten Abschnitten der zweiten und dritten Bereiche (12, 13) besteht, aber davon und vom dritten Pol (14) isoliert ist;
wobei der mindestens eine Kurzkanal-Feldeffekttransistor so eingerichtet ist, daß er einen Stromfluß im Basisbereich (4) steuert und vom Kollektorbereich (2) getrennt ist.

2. Halbleiterbauelement nach Anspruch 1, **dadurch gekennzeichnet, daß** der mindestens eine Kurzkanal-Feldeffekttransistor eine vertikale Kurzkanal-DMOS-Struktur aufweist.

3. Halbleiterbauelement nach Anspruch 1, **dadurch gekennzeichnet, daß** der mindestens eine Kurzkanal-Feldeffekttransistor eine laterale Kurzkanal-DMOS-Struktur aufweist.

4. Halbleiterbauelement nach einem der vorstehenden Ansprüche, **dadurch gekennzeichnet, daß** der mindestens eine Kurzkanal-Feldeffekttransistor einen Source-Pol (14) aufweist, wobei der mindestens eine Kurzkanal-Feldeffekttransistor so eingerichtet ist, daß er in einem Anreicherungsmodus arbeitet, um einen Stromfluß im Basisbereich (4) zu sperren, wenn ein Potential am Gate-Pol (18) kleiner ist als eine bezüglich des Source-Pols (14) gemessene Schwellenspannung.

5. Bauelement nach einem der vorstehenden Ansprüche, **dadurch gekennzeichnet, daß** das Material vom ersten Leitfähigkeitstyp ein p-Halbleiter, das Material vom zweiten Leitfähigkeitstyp ein n-Halbleiter, der erste Pol (6) ein Kollektor, der zweite Pol (10) ein Emitter, der dritte Pol (14) ein Source-Pol und das Substrat (2) der Kollektorbereich ist.

6. Bauelement nach einem der Ansprüche 1 bis 4, **dadurch gekennzeichnet, daß** das Material vom ersten Leitfähigkeitstyp ein p-Halbleiter, das Material vom zweiten Leitfähigkeitstyp ein n-Halbleiter, der erste Pol (10) ein Emitter, der zweite Pol (6) ein Kollektor, der dritte Pol (14) ein Source-Pol und der erste Bereich (70) der Kollektorbereich ist.

7. Bauelement nach einem der vorstehenden Ansprüche, **gekennzeichnet durch** einen metallischen Leiter (62, 63), der sich von einem an den zweiten Bereich (12) angrenzenden Teil des Basisbereichs (4) zu Bereichen (65) des Materials vom zweiten Leitfähigkeitstyp erstreckt, die innerhalb des ersten Bereichs (8) ausgebildet sind, wobei der metallische Leiter so angeordnet ist, daß er einen Basisstrom um den ersten Bereich herum verteilt.

8. Bauelement nach einem der Ansprüche 1 bis 6, **gekennzeichnet durch** einen metallischen Leiter (62, 63), der sich von einem an den zweiten Bereich (12) angrenzenden Teil des Basisbereichs (4) zu einem weiteren, an den ersten Bereich (8) angrenzenden Teil des Basisbereichs erstreckt, wobei der metallische Leiter so angeordnet ist, daß er einen Basisstrom um den ersten Bereich herum verteilt.

9. Bauelement nach einem der vorstehenden Ansprüche, **dadurch gekennzeichnet, daß** das Bauelement in einem Chip ausgebildet wird, der ein Substrat (2) aus einem Material vom ersten Leitfähigkeitstyp und einen vierten Bereich (20) mit dem Material vom ersten Leitfähigkeitstyp aufweist, wobei der Chip Kanten und eine Oberfläche aufweist und der vierte Bereich (20) sich an den Kanten des Chips vom Substrat zur Oberfläche erstreckt.

10. Bauelement nach einem der vorstehenden Ansprüche, **dadurch gekennzeichnet, daß** es ferner mindestens eine Feldplatte (40) aufweist.

11. Bauelement nach einem der vorstehenden Ansprüche, **dadurch gekennzeichnet, daß** es ferner Ringe (46) aus dem Material vom ersten oder zweiten Leitfähigkeitstyp innerhalb des Basisbereichs (4) aufweist.

12. Bauelement nach einem der vorstehenden Ansprüche, **dadurch gekennzeichnet, daß** es ferner zwischen dem Substrat (2) und dem Basisbereich (4) einen fünften Halbleiterbereich (50) aufweist, wobei der fünfte Bereich (50) eine niedrigere Dotierungskonzentration als das Substrat aufweist.

13. Bauelement nach einem der vorstehenden Ansprüche, **dadurch gekennzeichnet, daß** es ferner zwischen dem Basisbereich (4) und dem ersten Bereich (8) einen sechsten Halbleiterbereich (52) aufweist, wobei der sechste Bereich (52) stärker dotiert ist als der Basisbereich (4).

14. Bauelement nach einem der vorstehenden Ansprüche, **dadurch gekennzeichnet, daß** es ferner an einer Grenzfläche zwischen dem Basisbereich (4) und dem Substrat (2) unterhalb des mindestens einen Kurzkanal-Feldeffekttransistors einen stark dotierten Bereich (56) des Basisbereichs (4) aufweist.

15. Bauelement nach Anspruch 5, das ferner an den zweiten Pol angrenzende Anodenkurzschlüsse (60) aufweist.

## Revendications

1. Dispositif à semiconducteur intégré monolithiquement comprenant un étage de sortie de transistor bipolaire comportant une région de base (4) et une région de collecteur (2), dans lequel:
le transistor bipolaire est un transistor formé verticalement qui comprend une première borne (6) qui est connectée à un substrat semiconducteur (2) d'un premier type de conductivité formant le collecteur ou l'émetteur, la région de base (4) comprenant un matériau d'un second type de conductivité formé sur le substrat, une première région (8) du premier type de conductivité qui est connectée à une seconde borne (10); et
au moins un transistor à effet de champ à canal court qui comporte une borne de grille (18) en un matériau conducteur et qui comprend une seconde région (12) du premier type de conductivité, la seconde région (12) étant formée soit dans la région de base (4), soit dans une autre région du second type de conductivité qui est isolée de ladite région de base par une région du substrat semiconducteur (68), ladite autre région étant connectée à ladite région de base par un conducteur métallique,
dans lequel une troisième région (13) du second type de conductivité est formée dans la seconde région (12), une troisième borne (14) est connectée aux seconde et troisième régions (12, 13), ce qui atténue une action de thyristor, et la borne de grille (18) étant des sections adjacentes des seconde et troisième régions (12, 13) mais étant isolée de celles-ci et de la troisième borne (14),
dans lequel l'au moins un transistor à effet de champ à canal court est agencé de manière à commander une circulation de courant dans la région de base (4) et est séparé de la région de collecteur (2).

2. Dispositif à semiconducteur selon la revendication 1, **caractérisé en ce que** l'au moins un transistor à effet de champ à canal court comporte une structure de DMOS vertical à canal court.

3. Dispositif à semiconducteur selon la revendication 1, **caractérisé en ce que** l'au moins un transistor à effet de champ à canal court comporte une structure de DMOS latéral à canal court.

4. Dispositif à semiconducteur selon l'une quelconque des revendications précédentes, **caractérisé en ce que** l'au moins un transistor à effet de champ à canal court comporte une borne de source (14), l'au moins un transistor à effet de champ à canal court étant agencé pour fonctionner dans un mode enrichissement de manière à inhiber une circulation de courant dans la région de base (4) lorsqu'un potentiel au niveau de la borne de grille (18) est inférieur à une tension de seuil qui est mesurée par rapport à la borne de source (14).

5. Dispositif à semiconducteur selon l'une quelconque des revendications précédentes, **caractérisé en ce que** le matériau de premier type de conductivité est un semiconducteur de type P, le matériau de second type de conductivité est un semiconducteur de type N, la première borne (6) est un collecteur, la seconde borne (10) est un émetteur, la troisième borne (14) est une source et le substrat (2) est la région de collecteur.

6. Dispositif à semiconducteur selon l'une quelconque des revendications 1 à 4, **caractérisé en ce que** le matériau de premier type de conductivité est un semiconducteur de type P, le matériau de second type de conductivité est un semiconducteur de type N, la première borne (10) est un émetteur, la seconde borne (6) est un collecteur, la troisième borne (14) est une source et ladite première région (70) est la région de collecteur.

7. Dispositif selon l'une quelconque des revendications précédentes, **caractérisé par** un conducteur métallique (62, 63) qui s'étend depuis une partie de la région de base (4) adjacente à la seconde région (12) jusqu'à des régions (65) en le matériau de second type de conductivité formées dans la première région (8), le conducteur métallique étant agencé pour distribuer un courant de base autour de la première région.

8. Dispositif selon l'une quelconque des revendications 1 à 6, **caractérisé par** un conducteur métallique (62, 63) qui s'étend depuis une partie de la région de base (4) adjacente à la seconde région (12) jusqu'à une autre partie de la région de base adjacente à la première région (8), le conducteur métallique étant agencé pour distribuer un courant de base autour de la première région.

9. Dispositif selon l'une quelconque des revendications précédentes, **caractérisé en ce que** le dispositif est formé selon une puce comprenant un substrat (2) en un matériau de premier type de conductivité et une quatrième région (20) comprenant le matériau de premier type de conductivité, ladite puce ayant des bords et une surface, et la quatrième région (20) s'étendant, au niveau des bords de la puce, depuis le substrat jusqu'à la surface.

10. Dispositif selon l'une quelconque des revendications précédentes, **caractérisé en ce qu'**il comprend en outre au moins une plaque de champ (40).

11. Dispositif selon l'une quelconque des revendications précédentes, **caractérisé en ce qu'**il comprend en outre des anneaux (46) en le matériau de premier ou second type de conductivité à l'intérieur de la région de base (4).

12. Dispositif selon l'une quelconque des revendications précédentes, **caractérisé en ce qu'**il comprend en outre une cinquième région (50) en semiconducteur intermédiaire entre le substrat (2) et la région de base (4), la cinquième région (50) ayant une concentration de dopage inférieure à celle du substrat.

13. Dispositif selon l'une quelconque des revendications précédentes, **caractérisé en ce qu'**il comprend en outre une sixième région (52) en semiconducteur intermédiaire entre la région de base (4) et la première région (8), la sixième région (52) étant plus fortement dopée que la région de base (4).

14. Dispositif selon l'une quelconque des revendications précédentes, **caractérisé en ce qu'**il comprend en outre une région fortement dopée: (56) de la région de base (4) au niveau d'une interface entre la région de base (4) et le substrat (2) en dessous de l'au moins un transistor à effet de champ à canal court.

15. Dispositif selon la revendication 5, comprenant en outre des courts-circuits d'anode (60) adjacents à la seconde borne.
